# EUROPEAN PATENT APPLICATION

(11) **EP 4 530 194 A1**
(43) Date of publication of application: **02.04.2025**
(21) Application number: 24202669.8
(22) Date of filing: 25.09.2024
(51) Int. Cl.: B64D 27/351

(54) **THERMOELECTRIC FLEXIBLE COMPOSITE MATERIALS FOR ENERGY HARVESTING FROM AN AIRCRAFT ENVIRONMENT AND AN AIRCRAFT MANUFACTURING ENVIRONMENT**

(30) Priority: 27.09.2023 US 202363540741 P; 28.08.2024 US 202418817456
(71) Applicant: The Boeing Company, Arlington, VA 22202 (US); University of Washington, Seattle, WA 98105 (US)
(72) Inventor: GENET, Jean Nicolas, Arlington, 22202 (US); GROSS, Gwen Marie Lanphere, Arlington, 22202 (US); SLOAN, Steven John, Arlington, 22202 (US); MALAKOOTI, Mohammad, Arlington, 22202 (US); TETIK, Halil, Arlington, 22202 (US); HAN, Youngshang, Arlington, 22202 (US)
(74) Representative: Boult Wade Tennant LLP

(57) **Abstract**

Present apparatuses, systems, and methods are directed to the conservation of energy expended to power devices, components, systems, etc., on an aircraft, and to power aircraft manufacturing components used in the manufacture of an aircraft in an aircraft manufacturing facility using a highly flexible thermoelectric composite device (18) to generate electrical current by converting waste heat into electrical energy.

## Description

### TECHNOLOGICAL FIELD

The present disclosure relates generally to the field of thermoelectric devices. More specifically the present disclosure relates to the field of highly flexible thermoelectric devices.

### BACKGROUND

Many assembly and sub-assembly surfaces on an aircraft can emit heat as the assemblies and/or sub-assemblies themselves generate heat that migrates to a to an assembly and/or sub-assembly surface, or as such surfaces of aircraft assemblies and/or sub-assemblies that do not themselves generate heat may absorb heat from an environment (including, for example, environments that are external to an aircraft assembly and/or sub-assembly, etc.), with the surfaces then emitting the absorbed heat. In certain aircraft assemblies and/or subassemblies, generated heat is redirected from a heat-generating source and repurposed to provide heat to another location in an aircraft (e.g., redirected bleed air from engines, etc.). In other instances, heat leaving a surface of an aircraft structure surface is liberated to the surrounding environment (e.g., an area external to an aircraft, etc.) as "waste heat". In aircraft environments, including, for example, aircraft operation environments, aircraft manufacturing environments, etc., a significant amount of waste heat is generated during operation and manufacturing, with the waste heat released into surrounding aircraft environments.

Unless explicitly identified as such, no statement herein is admitted as prior art merely by its inclusion in the Technological Field and/or Background section.

### SUMMARY

Present examples are directed to harvesting heat energy, that can be, for example, in the form of waste heat, from an aircraft assembly surface and/or from an aircraft sub-assembly surface in an aircraft environment (equivalently referred to herein as an "aircraft assembly surface" and an "aircraft environment surface"). Further present examples are directed to harvesting heat energy, that can be in the form of waste heat, from a surface present in an aircraft manufacturing facility (equivalently referred to herein as an "aircraft manufacturing environment surface").

Present examples include an aircraft assembly and/or an aircraft sub-assembly (equivalently referred to herein as an "aircraft assembly") comprising an aircraft assembly surface configured to emit heat and at least one flexible thermoelectric composite device, with the flexible thermoelectric composite device comprising at least one electrical lead in communication with the flexible thermoelectric composite device, with the at least one electrical lead further in communication with an electrical circuit, and wherein the at least one flexible thermoelectric device is positioned adjacent to the aircraft assembly surface. The flexible thermoelectric composite device(s) may be a highly flexible thermoelectric composite device(s). For example, the flexible thermoelectric composite device(s) may be highly flexible to the extent that it can conform to a curved surface such as the aircraft assembly surface. All following references to at least one highly flexible thermoelectric composite device set out an optional implementation of an at least one flexible thermoelectric composite device. As just noted, the at least one highly flexible thermoelectric composite device may be highly flexible to the extent that it can conform to a curved surface such as the aircraft assembly surface. Also, all following references to at least one highly flexible thermoelectric composite device may be substituted with a reference to at least one flexible thermoelectric composite device.

In some examples, the at least one highly flexible thermoelectric device is in direct contact with the aircraft assembly surface.

In some examples, the highly flexible thermoelectric composite device is exposed to a temperature gradient and the highly flexible thermoelectric composite device is configured to sustain the temperature gradient during operation of the aircraft assembly.

In some examples, the aircraft assembly surface is configured to emit heat during operation of the aircraft.

In some examples, the aircraft assembly surface is configured to generate heat during operation of the aircraft.

In some examples, the aircraft assembly surface is configured to emit heat during aircraft operation, said aircraft assembly surface further comprising at least one of an aircraft engine surface, a bleed air duct surface, a heater surface, an electrical equipment bay surface, and an aircraft cabin assembly surface and/or an aircraft cabin sub-assembly surface (referred to equivalently herein as an "aircraft cabin assembly surface").

In some examples, the aircraft cabin assembly includes at least one of a sidewall, a passenger seat, an electronics unit, a duct, and combinations thereof.

Another present example is directed to an aircraft with the aircraft including an aircraft assembly and/or an aircraft sub-assembly (equivalently referred to herein as an "aircraft assembly") comprising an aircraft assembly surface configured to emit heat, and at least one highly flexible thermoelectric composite device, with the highly flexible thermoelectric composite device comprising at least one electrical lead in communication with the highly flexible thermoelectric composite device, with the at least one electrical lead further in communication with an electrical circuit, and wherein the at least one highly flexible thermoelectric device is positioned adjacent to the aircraft assembly surface.

In some examples, the highly flexible thermoelectric composite device is in direct contact with the aircraft assembly surface.

In some examples, the highly flexible thermoelectric composite device is in direct contact with the aircraft assembly surface configured to emit heat.

In some examples, the highly flexible thermoelectric composite device is incorporated into an aircraft assembly surface, with the aircraft assembly surface configured to emit heat.

Further present examples are directed to a method of harvesting waste energy in an aircraft, with the method including positioning at least one highly flexible thermoelectric composite device adjacent to an aircraft assembly surface of an aircraft, with the aircraft assembly surface configured to emit an amount of heat, with the highly flexible thermoelectric composite device comprising at least one electrical lead in communication with the flexible thermoelectric composite device, with the at least one electrical lead further in communication with an electrical circuit, converting into electrical energy an amount of heat transferred to the highly flexible thermoelectric composite device from the aircraft assembly surface onto which highly flexible thermoelectric composite device is positioned, and directing the electrical energy from the highly flexible thermoelectric composite device to the electrical circuit.

In some examples, the method further includes powering an electrically-powered aircraft component with electrical energy directed from the highly flexible thermoelectric composite device, with the electrically powered aircraft component in communication with the electrical circuit.

In some examples, the method further includes charging an energy storage device that can be, for example, an energy storage battery with at least a portion of the electrical energy directed from the highly flexible thermoelectric composite device to the energy storage device, with the energy storage device in communication with the electrical circuit.

In some examples, the aircraft assembly surface includes at least one of an aircraft engine surface, a bleed air duct surface, a heater surface, an electrical equipment bay surface, and an aircraft cabin assembly surface.

In some examples, the aircraft cabin assembly surface comprises at least one of a sidewall surface, a passenger seat surface, an electronics equipment bay surface, a duct surface, and combinations thereof.

In some examples, the method further includes positioning a plurality of highly flexible thermoelectric composite devices adjacent to the aircraft assembly surface.

In some examples, the method further includes positioning at least one highly flexible thermoelectric composite device in direct contact with the aircraft assembly surface.

In some examples, the method further includes incorporating at least one highly flexible thermoelectric composite device into the aircraft assembly surface.

In some examples, the electrically-powered aircraft component comprises at least one of a temperature sensor, a power sensor, a lighting array, safety lighting, LED lighting, an ambient light sensor, a flight deck instrument panel, emergency equipment, communications equipment, an auxiliary power unit, fire suppression equipment, and combinations thereof.

In some examples, the highly flexible thermoelectric composite device is individually responsible for powering the electrically-powered aircraft component.

In some examples, the highly flexible thermoelectric composite device is exclusively responsible for powering the electrically-powered aircraft component.

In some examples, the highly flexible thermoelectric composite device is an auxiliary power source provided to the electrically-powered aircraft component.

In some examples, the method further includes powering an electrically-powered aircraft component from the energy storage device, said electrically-powered aircraft component comprising at least one of a temperature sensor, a power sensor, a lighting array, an ambient light sensor, a flight deck instrument panel, emergency equipment, communications equipment, an auxiliary power unit, fire suppression equipment, and combinations thereof.

In some examples, a voltage booster is in communication with the electrical circuit.

In some examples, the energy storage device is a rechargeable battery.

In some examples, the energy storage device is a rechargeable lithium ion battery.

Another example is directed to a method of manufacturing an aircraft in an aircraft manufacturing environment that can be an aircraft manufacturing facility, that can be an aircraft manufacturing facility "shop floor", with the method including providing an aircraft manufacturing environment surface configured to emit heat, with the aircraft manufacturing environment surface configured to emit an amount of heat. The method further includes positioning at least one highly flexible thermoelectric composite device adjacent to the aircraft manufacturing environment surface, with the highly flexible thermoelectric composite device comprising at least one electrical lead in communication with the highly flexible thermoelectric composite device, with the at least one electrical lead further in communication with an electrical circuit, converting into electrical energy an amount of heat from the aircraft manufacturing environment surface, and directing the electrical energy from the highly flexible thermoelectric composite device to the electrical circuit.

In some examples, the method further includes powering an electrically-powered component with electrical energy directed from the at least one highly flexible thermoelectric composite device to the electrically-powered component, with the electrically-powered component in communication with at least one of the highly flexible thermoelectric composite device and further in communication with the electrical circuit.

In some examples, the method further includes charging an energy storage device with electrical energy directed from the at least one flexible thermoelectric composite device, with the energy storage device in communication with the electrical circuit during a battery charging cycle.

In some examples, the method further includes positioning the at least highly flexible thermoelectric composite device in direct contact with the aircraft manufacturing environment surface.

In some examples, the method further includes incorporating the at least highly flexible thermoelectric composite device into the aircraft manufacturing environment surface.

In some examples, the method further includes positioning a plurality of highly flexible thermoelectric composite devices in direct contact with the aircraft manufacturing environment surface.

In some examples, the method further includes positioning the at least highly flexible thermoelectric composite device in direct contact with the aircraft manufacturing environment surface.

In some examples, the at least one highly flexible thermoelectric composite device is individually responsible for powering the electrically-powered component.

In some examples, the at least one highly flexible thermoelectric composite device is a source of auxiliary power provided to the electrically-powered component.

In some examples, the method further includes powering an electrically-powered component with electrical energy directed to the electrically powered component from the energy storage device.

Another example is directed to an electrically-powered component powered at least in part by electrical energy directed to an electrically-powered component from a highly flexible thermoelectric composite device according to a method including providing an aircraft manufacturing environment surface, with the aircraft manufacturing environment surface configured to emit heat. The method further includes positioning at least one highly flexible thermoelectric composite device adjacent to the aircraft manufacturing environment surface, with the highly flexible thermoelectric composite device comprising at least one electrical lead in communication with the highly flexible thermoelectric composite device, with the at least one electrical lead further in communication with an electrical circuit, converting into electrical energy an amount of heat from the aircraft manufacturing environment surface, and directing the electrical energy from the highly flexible thermoelectric composite device to the electrical circuit.

A further example is directed to an electrically-powered component powered at least in part by electrical energy directed to an electrically-powered component from a highly flexible thermoelectric composite device according to a method including providing an aircraft manufacturing environment surface, with the aircraft manufacturing environment surface configured to emit heat. The method further includes positioning at least one highly flexible thermoelectric composite device adjacent to the aircraft manufacturing environment surface, with the highly flexible thermoelectric composite device comprising at least one electrical lead in communication with the highly flexible thermoelectric composite device, with the at least one electrical lead further in communication with an electrical circuit, converting into electrical energy an amount of heat from the aircraft manufacturing environment surface, and directing the electrical energy from the highly flexible thermoelectric composite device to the electrical circuit. The method further includes directly charging an energy storage device with electrical energy directed from the at least one flexible thermoelectric composite device, with the energy storage device in communication with the electrical circuit during a battery charging cycle, and powering an electrically-powered component with electrical energy directed to the electrically-powered component from the energy storage device.

A further example is directed to an aircraft manufactured according to a method of manufacturing, with the method including providing a structure configured to emit heat during operation, with the structure comprising a structure surface, and with the structure surface configured to emit an amount of heat during operation of the structure. The method further includes positioning at least one highly flexible thermoelectric composite device adjacent to the structure, with the highly flexible thermoelectric composite device comprising at least one electrical lead in communication with the highly flexible thermoelectric composite device, with the at least one electrical lead further in communication with an electrical circuit, converting into electrical energy an amount of heat from the structure surface, and directing the electrical energy from the highly flexible thermoelectric composite device to the electrical circuit.

An example is directed to an aircraft manufactured according to a method of manufacturing an aircraft in an aircraft manufacturing facility (that can include, for example, harvesting energy from the "shop floor" of the aircraft manufacturing environment, etc.), with the method including providing an aircraft manufacturing environment surface, with the aircraft manufacturing environment surface configured to emit heat. The method further includes positioning at least one highly flexible thermoelectric composite device adjacent to the aircraft manufacturing environment surface, with the highly flexible thermoelectric composite device comprising at least one electrical lead in communication with the highly flexible thermoelectric composite device, with the at least one electrical lead further in communication with an electrical circuit, converting into electrical energy an amount of heat from the aircraft manufacturing environment surface, and directing the electrical energy from the highly flexible thermoelectric composite device to the electrical circuit.

In some examples, the method further includes powering an electrically-powered component with electrical energy directed from the at least one highly flexible thermoelectric composite device to the electrically-powered component, with the electrically-powered component in communication with at least one of the highly flexible thermoelectric composite device and the electrical circuit.

In some examples, the method further includes directly charging an energy storage device with electrical energy directed from the at least one flexible thermoelectric composite device, with the energy storage device in communication with the electrical circuit during a battery charging cycle, and powering an electrically-powered component with electrical energy directed to the electrically-powered component from the energy storage device.

The features, functions and advantages that have been discussed can be achieved independently in various examples or may be combined in yet other examples, further details of which can be seen with reference to the following description and the drawings.

### BRIEF DESCRIPTION OF THE DRAWINGS

Having thus described variations of the disclosure in general terms, reference will is now made to the accompanying drawings, which are not necessarily drawn to scale, and wherein:
FIG. 1 is an illustration of a vehicle in the form of an aircraft, according to present examples;
FIG. 1A is an illustration of a vehicle in the form of an aircraft positioned in an aircraft manufacturing environment in the form of an aircraft manufacturing facility, according to present examples;
FIG. 2 is an illustration of an aircraft assembly in the form of an aircraft engine comprising the highly flexible thermoplastic composite device in place in direct contact with an engine surface, according to present examples;
FIG. 3 is an illustration of an aircraft assembly in the form of an auxiliary power unit comprising the highly flexible thermoplastic composite device in place in direct contact with an auxiliary power unit surface, according to present examples;
FIG. 4 is an aircraft assembly in the form of an electronic equipment bay comprising the highly flexible thermoplastic composite device in place in direct contact with an electronic equipment bay surface, according to present examples;
FIG. 5A is a drawing of an electrical circuit comprising the highly flexible thermoplastic composite device, according to present examples;
FIG. 5B is a drawing of an electrical circuit comprising the highly flexible thermoplastic composite device, according to present examples;
FIG. 6A is a box diagram showing an aircraft assembly having an aircraft assembly surface and comprising a highly flexible thermoelectric composite device, according to present examples;
FIG. 6B is a box diagram showing an aircraft assembly having an aircraft assembly surface comprising a highly flexible thermoelectric composite device in communication with an electrical circuit and an aircraft component, according to present examples;
   FIG. 6C is a box diagram of an aircraft component of an aircraft comprising a highly flexible thermoelectric composite device configured to power the aircraft component, according to present examples;
FIG. 6D is a box diagram showing an aircraft component of an aircraft comprising a highly flexible thermoelectric composite device configured to power the aircraft component, according to present examples;
FIG. 6E is a box diagram showing an aircraft comprising an aircraft component comprising a highly flexible thermoelectric composite device configured to power the aircraft component and charge an energy storage device, according to present examples;
FIG. 6F is a box diagram showing an aircraft comprising an aircraft component comprising a highly flexible thermoelectric composite device configured to power a first aircraft component, charge an energy storage device, and direct electrical power to a second aircraft component according to present examples;
FIG. 6G is a box diagram showing an aircraft component of an aircraft comprising a highly flexible thermoelectric composite device configured to power the aircraft component used to manufacture an aircraft within an aircraft manufacturing environment that can be an aircraft manufacturing facility, according to present examples;
FIG. 6H is a box diagram showing an aircraft component of an aircraft comprising a highly flexible thermoelectric composite device configured to power the aircraft component and charge an energy storage device, according to present examples;
FIG. 6I is a box diagram showing an aircraft component of an aircraft comprising a highly flexible thermoelectric composite device configured to power a first aircraft component, charge an energy storage device, and direct power to a second aircraft manufacturing component, according to present examples;
FIG. 7 is a view of a fabrication progression for a highly flexible thermoelectric composite device, according to present examples;
FIG. 8 is an exploded view of a highly flexible thermoelectric composite device, according to present examples;
FIG. 9 is a perspective view of a highly flexible thermoelectric composite device, according to present examples;
FIG. 10 is a perspective view of a highly flexible thermoelectric composite device, according to present examples;
FIG. 11 is a perspective view of a highly flexible thermoelectric composite device in a highly deformed state, according to present examples;
FIG. 12 is a perspective view of a highly flexible thermoelectric composite device in a highly deformed state, according to present examples;
FIG. 13 is a view of a plurality of high flexibility thermoplastic composite devices placed in series, according to present examples;
FIG. 14 is a schematic view of a plurality of high flexibility thermoplastic composite devices placed in series, according to present examples;
FIG. 15 is a schematic view of a plurality of high flexibility thermoplastic composite devices placed in series, according to present examples;
FIG. 16 is a flowchart outlining a method, according to present examples;
FIG. 17 is a flowchart outlining a method, according to present examples;
FIG. 18 is a flowchart outlining a method, according to present examples;
FIG. 19 is a flowchart outlining a method, according to present examples;
FIG. 20 is a flowchart outlining a method, according to present examples;
FIG. 21 is a flowchart outlining a method, according to present examples;
FIG. 22 is a flowchart outlining a method, according to present examples;
FIG. 23 is a flowchart outlining a method, according to present examples;
FIG. 24 is a flowchart outlining a method, according to present examples; and
FIG. 25 is a flowchart outlining a method, according to present examples.

### DETAILED DESCRIPTION

Aircraft structures that can include aircraft assemblies, aircraft sub-assemblies, installations on and into aircraft, (structures, assemblies, sub-assemblies, installations in and/or on aircraft equivalently referred to herein as "aircraft assemblies") can themselves generate heat and emit heat from aircraft assembly surfaces, or that can be located adjacent to various heat-generating aircraft assemblies such that the surfaces of non-heat-generating assemblies can still comprise surfaces that can emit absorbed heat. Aircraft assembly surfaces can emit significant amounts of heat and experience substantial temperature gradients in operation. Aircraft assemblies comprise aircraft assembly surfaces that can emit amounts of heat, such as, for example, during operation of the aircraft and/or operation of the aircraft assembly.

For example, aircraft engines, in operation, generate significant heat that can be redirected and/or repurposed, in part, as bleed air that can assist in aircraft cabin heating, and/or other heating functions. In addition, other heat-generating aircraft assemblies can include, for example, auxiliary power units, electronic equipment bays/panels, passenger seats (e.g., cushions, armrests, sidewalls, etc.). According to present examples, such heat-generating aircraft assemblies comprise heat-emitting surfaces.

In addition, regions within an aircraft, and some aircraft assemblies do not themselves generate heat in operation, but can comprise surfaces that can absorb or reflect heat and then emit or reflect heat. Such assembly surfaces may experience a thermal gradient as they absorb amounts of heat from adjacent structures in operation, for example. Still further, various aircraft assembly surfaces, such as passenger seat surfaces, aircraft window surfaces, sidewall surfaces, etc., can emit amounts of heat, (e.g., while an aircraft is in operation including, e.g., in flight, during taxiing, while stationary on a tarmac or at a gate, etc.)

Present examples are directed to harvesting, capturing, and/or repurposing at least a portion of heat emanating from (e.g., emitting from) heat-generating and/or heat-emitting aircraft assembly surfaces, e.g., "waste heat", and converting such waste heat into electricity by positioning and locating flexible/highly flexible thermoelectric composite devices (referred to equivalently herein as "TE devices", and subsequent references to "highly flexible" may be replaced with references to "flexible") proximate to, adjacent to, in direct contact with, and/or incorporated integrally into aircraft assembly surfaces that are capable of emitting collected, absorbed, reflected, and/or generated heat.

According to present examples, highly flexible (and, optionally, highly efficient) thermoelectric composite devices are positioned in contact with aircraft assembly surfaces that are configured to emit heat, with an amount of heat energy (e.g., "waste heat") emitted from such aircraft assembly surfaces (previously being lost to the surrounding environment) now being harnessed, harvested, "scavenged", and otherwise converted into electrical energy that can be: 1) directed to power an electrical component directly, 2) directed to an electrical circuit to power an electrical component in communication with the electrical circuit; and/or 3) directed to and stored in a rechargeable battery that is directly in communication with the TE device or that is in communication with the electrical circuit. The converted electricity can then be delivered, for example, on demand, to power aircraft components in an aircraft environment that can include components on aircraft and/or to power electrically-powered devices and/or systems at an aircraft manufacturing facility, for example.

That is, the highly flexible thermoelectric composite devices can deliver converted electrical energy (that is converted from heat at an aircraft assembly surface or an aircraft environment surface) directly or indirectly to power an electrically-powered aircraft environment component. The highly flexible thermoelectric composite devices can further deliver electrical energy converted from a heat-emitting surface to a rechargeable energy storage device, for example, for use in directly or indirectly powering electrically-powered aircraft components on an aircraft or electrically-powered components and systems in an aircraft manufacturing facility (referred to herein as also being an "aircraft environment").

Direct powering of components from the electrical energy converted from heat energy by the TE devices, contemplates TE devices in direct communication with an electrically-powered aircraft component (e.g., direct contact with an aircraft assembly surface mor an aircraft environment surface). For example, an aircraft component, that is to be electrically-powered, can itself comprise the TE device, or the component can comprise an energy storage device that is charged by the electricity produced by the TE device. In other examples, electrically-powered components, said to be "indirectly powered", can be in communication with an electrical circuit, with the electrical circuit further in communication with at least one of the TE device, and an energy storage device that can be charged by electricity generated by the TE device from heat emitted from a surface.

In addition, according to further present examples, highly efficient and highly flexible thermoelectric composite devices are positioned in contact with heat-emitting aircraft manufacturing facility surfaces, for example, during manufacture of an aircraft (referred to equivalently herein as "aircraft environment surfaces"). Such aircraft environment surfaces can include, for example, facility windows, roofing, lamps, machinery, ovens, heaters, and any physical structure having a surface that can emit heat. Such aircraft manufacturing facility surfaces present in an aircraft manufacturing facility that are configured to collect and/or emit heat during, previously emitted heat energy (e.g., "waste heat") that was previously lost to the surrounding environment. According to present examples, by associating the highly flexible thermoelectric composite devices with heat-emitting aircraft manufacturing facility surfaces, the "waste heat" can now be harnessed, harvested, "scavenged", and otherwise converted into electrical energy that can be directed to power, for example, an aircraft manufacturing facility component, or system that is placed in communication with the highly flexible thermoelectric device, or that is placed into communication with a circuit that is in communication with the highly flexible thermoelectric device. In further present examples, the converted electrical energy can be directed to and stored in a rechargeable energy storage device in communication with the TE device (directly or via an electrical circuit, etc.), with the stored electrical energy then delivered to an aircraft manufacturing facility component to power, on demand, aircraft manufacturing facility components in an aircraft manufacturing facility.

In further examples, the highly flexible thermoelectric composite device is itself incorporated (e.g., integrally incorporated) into an aircraft manufacturing facility component having a surface that is configured to emit heat during aircraft manufacturing in an aircraft manufacturing facility, such that the heat produced during operation of the aircraft manufacturing facility component is converted by the TE device into electrical current that can be delivered back into the aircraft manufacturing component to power the component, or to power a feature of the component (e.g., a light or power indicator associated with the component, etc.), or to charge a battery that can be integrated into a component to power the component.

According to present examples, the heat-emitting surface of an aircraft component and/or an aircraft manufacturing facility surface (which can support and comprise and which can directly contact the present TE device) can be planar, non-planar, contoured (e.g., regular or irregular geometry, etc.), with the highly flexible TE device configured to be pliable enough to conform to, and remain in place in contact with, a heat-emitting aircraft assembly surface or a heat-emitting aircraft environment surface while maintaining the highly flexible TE device in direct contact with the heat-emitting surface.

In one example, the TE device comprises leads that are in communication with an electrical circuit. As the aircraft assembly surfaces (and/or aircraft manufacturing facility surfaces) emit heat, the associated TE device positioned adjacent to, (e.g., in direct contact with, integral with, etc.) the heat-emitting surface experiences or "sustains" a temperature gradient (referred to equivalently herein as a "thermal gradient", and/or "and/or "heat flux") across the TE device structure, and the TE device converts an amount of the "waste heat" at the aircraft component surface into an electrical charge. When the TE device is placed into communication with an electrical circuit, the TE device delivers a produced electrical charge to the electrical circuit.

According to present examples, the electrical circuit in communication with the TE device can be an existing electrical circuit that is part of typical aircraft electrical architecture. In further present examples, the electrical circuit in communication with the TE device can be an electrical circuit dedicated to the TE device. That is, according to present examples, an electrical circuit can comprise, or otherwise be in communication with, a conventional power source in addition to the auxiliary power source that is the TE device. In this example, the TE device can be an auxiliary power source in an electrical circuit, with the TE device continuing to supply electrical energy to the circuit in the absence of conventional electrical power (e.g., in the event of a conventional power interruption aboard the aircraft, etc.). In other present examples, the electrical circuit can be an additional electrical circuit dedicated to the TE device as an exclusive power source in an electrical circuit.

According to present examples, an aircraft component or system that can be an electrically-powered aircraft component or system can be in communication with, and powered by, the TE device via the electrical circuit. Should an aircraft experience an electrical outage, the electricity supplied to the electrical circuit by the TE device can continue to power aircraft components/systems that are in communication with the TE device via the electrical circuit, for example, with the electrically-powered aircraft component/system remaining in uninterrupted operation for the duration of such unplanned aircraft electrical outage. In this example, the TE device can provide a continuous source of electricity such that aircraft power need not be diverted (e.g., in the form of "backup power", etc.) to run the aircraft component/system that is in communication with the TE device via the electrical circuit.

In addition, according to further present examples, an energy storage device (e.g., a rechargeable energy storage device that can be lithium ion battery, etc.) can be in communication with the electrical circuit, with the TE device delivering an electrical charge to the energy storage device as well as the TE device powering an electrical component. In further present examples, power stored in the energy storage device can be delivered to aircraft components when the aircraft is not in operation (e.g., when an aircraft structure is not experiencing a thermal gradient to run the TE device. In further present examples, the energy storage device can be in communication with further circuits to run additional aircraft components/systems, etc. Electrically-powered aircraft components/systems can include, for example, sensors, indicators, lighting banks, emergency equipment, communications equipment, navigation equipment, ventilation systems, etc.

The electrical circuits that are in communication with the present TE device can further be in communication with an indicator powered from the circuit that indicates the generation of electricity by the TE devices, or that indicates that electrical energy is being delivered from, or supplied to an energy storage device, for example.

As mentioned herein, the TE device can be an exclusive power source for an aircraft component. In addition, the TE device can be configured (e.g., in communication with an electrical circuit) as an auxiliary power source, with the TE devices in either mode configured to direct an electrical charge (converted from heat) to a chargeable energy storage device that can be regulated to deliver electrical energy from the energy storage device as needed.

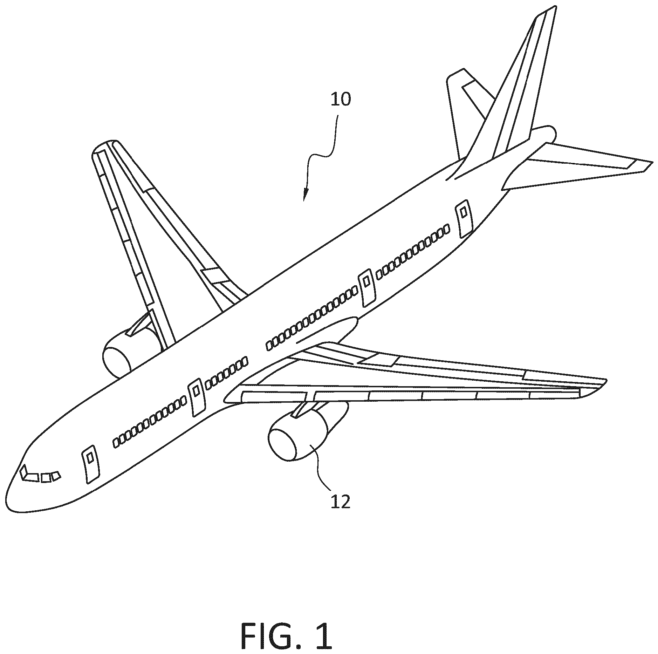

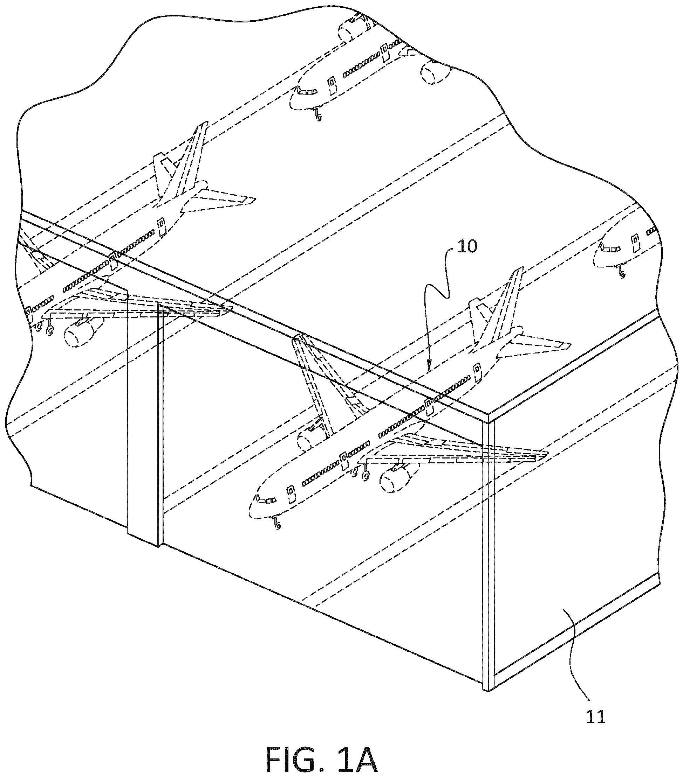

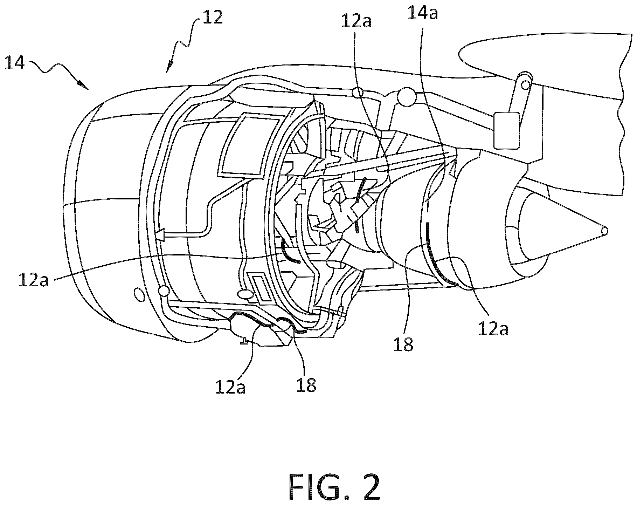

FIG. 1 shows a vehicle in the form of an aircraft 10 having aircraft engines 12 provided for propulsion. FIG. 1A shows an aircraft 10 in an aircraft manufacturing facility 11, according to present examples. FIG. 2 is a partially exposed view of an aircraft assembly 14 having aircraft assembly surfaces that emit heat during operation, with aircraft assembly 14 having aircraft assembly surfaces 14a (in the form of an aircraft engine 12 having aircraft engine surfaces 12a). As shown in FIG. 2, highly flexible thermoelectric composite devices 18 are positioned conformally, adjacent to, and further in direct contact with respective aircraft assembly surfaces 12a, 14a that emit heat during operation. As further shown in FIG. 2, aircraft assembly surfaces can be or can otherwise comprise non-planar surfaces, and can present a contoured (e.g., non-planar) surface onto which the TE devices 18 are incorporated.

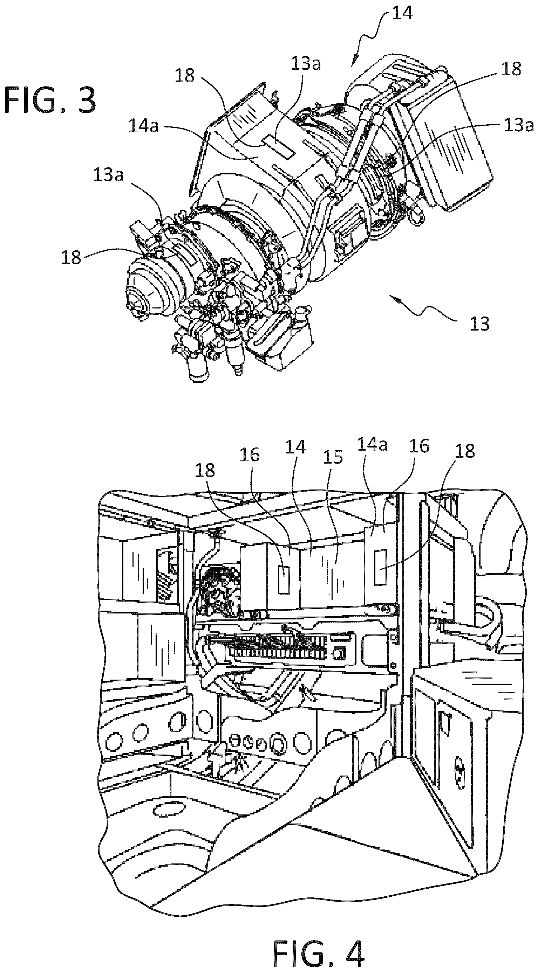

FIG. 3 is a partially exposed view of an auxiliary power unit 13 as another type of aircraft assembly 14 having surfaces that can generate heat during operation, and having an aircraft assembly surface 14a (also denoted in FIG. 3 as auxiliary power unit surface 13a) that can emit heat and onto which a TE device 18 can be placed, for example, in direct contact. In another example, FIG. 4 illustrates an electrical equipment bay 15 as a further type of aircraft assembly 14 having an aircraft assembly surface 14a (also denoted in FIG. 4 as an electronic equipment bay surface 16) that can emit heat and onto which onto which a TE device 18 can be placed, for example, in direct contact.

According to present examples, an aircraft assembly comprises an aircraft assembly surface with at least one TE device placed in direct contact with the aircraft assembly surface. The aircraft assembly surface can be planar, and in addition, the aircraft structure surface can be contoured (e.g., non-planar), with the highly flexible TE device configured to be sufficiently pliable (e.g., bendable) to conform to an aircraft structure surface contour, maintaining the TE device in direct contact with the aircraft assembly surface contour.

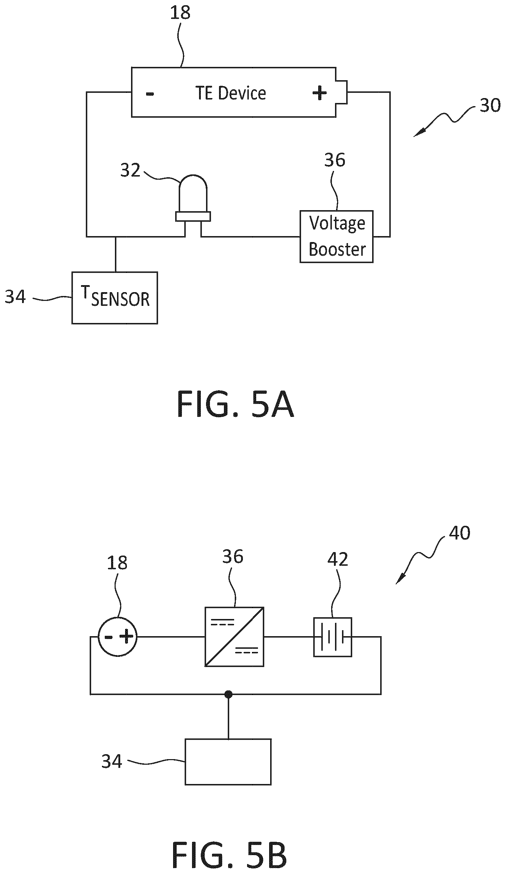

As stated herein, the electrical circuits in communication with the present TE devices can further be in communication with an indicator powered from the circuit that indicates the generation of electricity by the TE devices, or that indicates that electrical energy is being delivered from, or supplied to an energy storage device. FIGs. 5A and 5B are circuit diagrams illustrating present examples.

FIG. 5A shows an electrical circuit 30 that can be present and located within an electrical architecture of an aircraft of the type shown in FIG. 1, for example. As shown in FIG. 5A, electrical circuit 30 includes at least one highly flexible thermoelectric composite 18 in communication with an indicator 32 and a voltage booster 36 along the electrical circuit 30. When TE device 18 is operational, converting heat into electricity, and generating an electrical current, the TE device 18 is experiencing a thermal gradient; an indication that a temperature change/increase is occurring across its area, and evidencing a temperature change/increase occurring at or in a region near the aircraft structure that is contacting the TE device. Voltage booster 36 in electrical circuit 30 can further enhance the voltage produced by the TE device in electrical circuit 30.

FIG. 5B shows an alternate electrical circuit 40, according to present examples, with the TE device 18 in communication with electrical circuit 40 that further comprises a voltage booster 36 that can be positioned, for example, in electrical circuit 40 between TE device 18 and rechargeable energy storage device 42 (that can be, for example, a rechargeable lithium ion battery, etc.), with electrical circuit 40 further in communication with an electrical component 34 that can be, for example a temperature sensor.

In further present examples, the TE devices can be placed in contact with, or in proximity to, aircraft assembly surfaces that typically are not configured to emanate heat, and in aircraft locations where the swift detection of an undesirable detected temperature change would be beneficial (e.g., a swiftly detected temperature increase, in, for example, real time, with real time defined herein as being a time duration ranging from 5 seconds to 30 seconds or from about 5 seconds to about 30 seconds). In these aircraft structure locations that are not expected to experience a temperature increase, when the present TE devices experience even a minimal thermal gradient ranging from 3°C to 5°C or from about 3°C to about 5°C , the TE devices will begin to covert heat to produce an electrical current that can be directed to, for example, an electrical circuit that comprises an electrically-powered indicator. The generation of electricity by the TE devices can be detected and indicated by an indicator, for example, as an alert that a particular aircraft structure or region proximate to the aircraft structure is experiencing a temperature increase that may be an unwanted temperature increase. In this mode, the TE device itself can act as a temperature sensor.

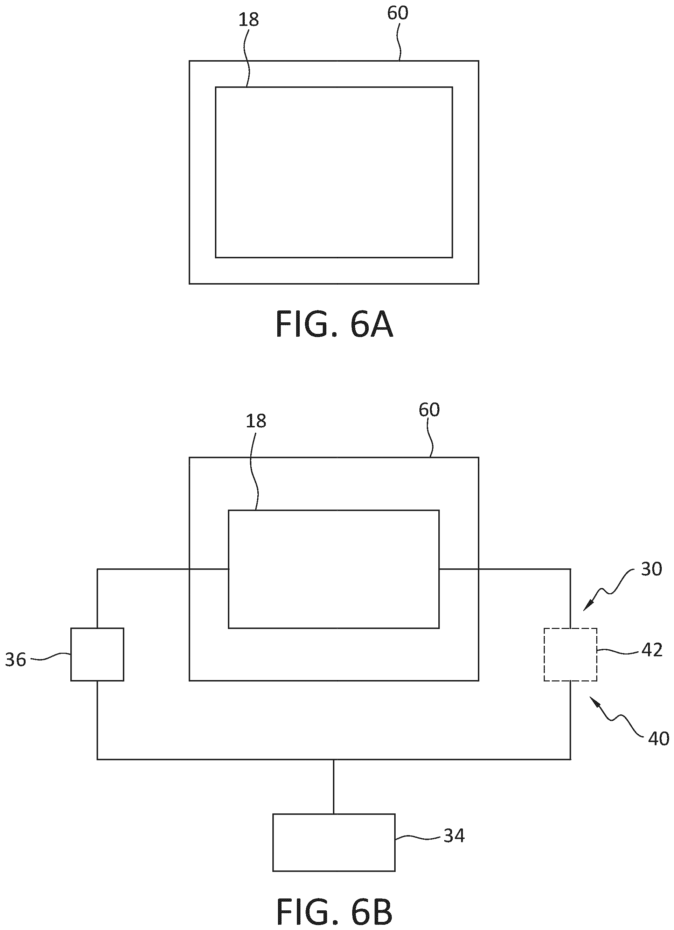

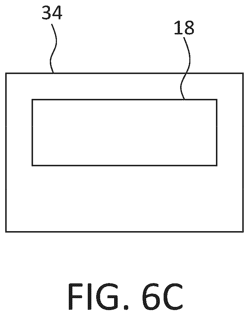

FIGs 6A, 6B, and 6C are diagrams outlining further present examples. FIG. 6A is a block diagram illustrating an aircraft assembly surface that comprises or otherwise incorporates the present TE device 18. FIG. 6B shows the aircraft structure 60 of FIG. 6A (incorporating TE device 18), with TE device 18 in communication with an electrical circuit 30 showing the components in communication with electrical circuit 30 as described herein and as shown in FIG. 5A. When an energy storage device 42 is placed in communication with the electrical circuit, the electrical circuit can be designated as electrical circuit 40, with an electrical circuit 40 showing the components in

As shown in FIG. 6C, further present examples are directed to an electrically-powered component 34 that can be, for example, a temperature sensor, etc. As shown in FIG 6C, an electrically-powered aircraft component can be in direct contact with a present TE device 18, for example, to directly power the component 34. As mentioned herein, the TE device can be an exclusive power source for an aircraft component, and the TE device also can be configured in an electrical circuit as an auxiliary power source for4 an aircraft component, with the TE device in either mode configured to direct an electrical charge produced by the TE device to a (re)chargeable energy storage device that can be regulated to deliver electrical energy from the energy storage device as needed.

The present TE devices can be manufactured as extremely thin devices having a total thickness ranging from 2 mm to 2.4 or from about 2 mm to about 2.4 mm, facilitating placement of the present TE devices into various locations on an aircraft, and in contact with aircraft assembly surfaces on an aircraft that had not been possible previously (e.g., difficult-to-access locations, etc.), and/or placement at locations between structures that exhibited significant space restrictions and/or tolerances between structures, with the available space between structures (e.g., "gaps") having a width of only a few or only several millimeters. According to present examples, the width of the present TE devices (having a width ranging, ranging from 10 mm or about 10 mm for TE tensile test specimens to 32 mm or about 32 mm for TE devices) allows such present TE devices to occupy previously unoccupied space between closely and adjacently-positioned aircraft assemblies, for example.

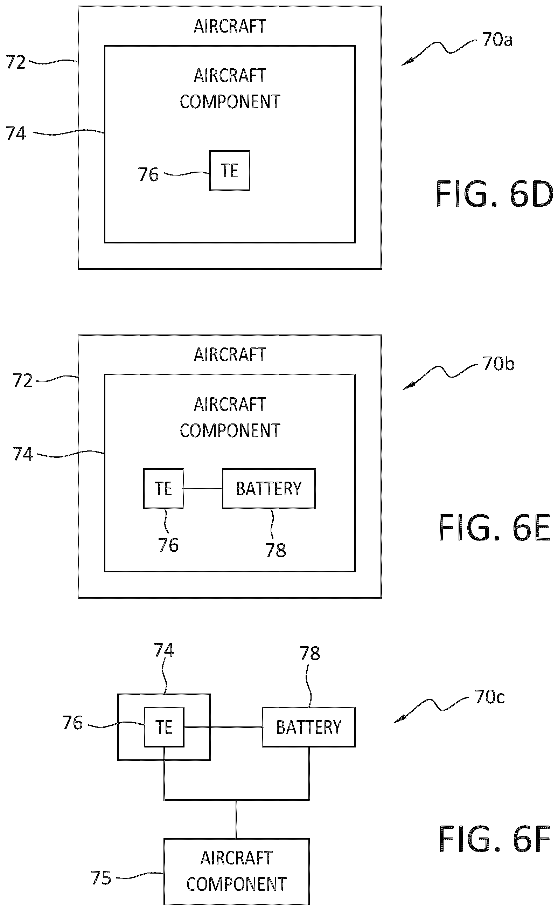

Further present examples are directed to aircraft comprising an aircraft component, with the aircraft component further comprising a highly flexible thermoelectric composite device. FIG. 6D shows a box diagram 70a comprising an aircraft 72 that comprises an aircraft component 74, and with the aircraft component 74 comprising, or otherwise in communication with TE device 76 via, for example, an electrical circuit, etc. According to present examples, when aircraft component 74 is in operation, an aircraft component surface can experience a temperature change that can be a temperature increase (e.g., the component surface can sustain a temperature gradient from an initial temperature when the component is at rest to a "working" temperature when the component is in operation itself and emitting heat or when component surrounding experience a heat increase and the component surface temperature increase such that the component surface can emit heat.

That is, the aircraft component 74 further can be a non-operational component that may not generate heat itself, but that can absorb an amount heat from a nearby environment or from a heat source within or from outside of the aircraft, (e.g., the sun) and then radiate or otherwise emit at least a portion of the heat from the component surface, or otherwise transfer a portion of the heat that was absorbed (e.g., a passenger seat, armrest, headrest that can absorb heat from a passer occupying the seat; a window or sidewall that can absorb radiant energy from solar energy; a stationary aircraft component or aircraft cabin component that is positioned in a region that is sustains a temperature change and/or temperature increase when other components or structure are in operation and emit heat etc.). As shown in FIG. 6D, the TE device is positioned adjacent to or in direct contact with an aircraft component surface of the aircraft component 74 such that the TE device reacts to the change in temperature of the aircraft component surface and experiences a temperature gradient across the TE device that enables the TE device to convert heat energy into electrical current from the scavenged waste heat at the aircraft component surface of the aircraft component. As shown in FIG. 6D, according to one example, if the aircraft component is itself or comprises an electrically-powered aircraft component, the electrical current generated by the TE device can be directed to via an electrical circuit back into the aircraft component.

FIG. 6E shows a box diagram 70b, directed to another example where TE device 76 is further in communication, for example, via an electrical circuit, with an energy storage device 78. As shown in FIG. 6E, the TE device is positioned adjacent to or in direct contact with an aircraft component surface of the aircraft component 74 such that the TE device reacts to the change in temperature of the aircraft component surface and experiences a temperature gradient across the TE device that enables the TE device to convert heat energy into electrical current from the scavenged waste heat at the aircraft component surface of the aircraft component. According to one present example, in diagram 70b, if the aircraft component is itself or comprises an electrically-powered aircraft component, 1) the electrical current generated by the TE device can be directed from the TE device via an electrical circuit back into the aircraft component; and/or 2) the electrical current generated by the TE device can be directed from the TE device via an electrical circuit to the energy storage device (that can be, for example, a rechargeable lithium ion battery; and 3) an electrical charge stored in the energy storage device can be released, on demand, and directed to power the electrically-powered aircraft component.

FIG. 6F shows a block diagram 70c showing another present example, where a first aircraft component 74 comprises the TE device 76 configured to scavenge and redirect energy in the form of heat energy from a first aircraft component surface into converted electrical energy, with the electrical energy directed from the TE device 76 via an electrical circuit: 1) to an energy storage device 78 that is in communication with the TE device; and/or 2) to a second aircraft component 75 that is also in communication with an electrical circuit; and/or to an energy storage device 78. In this example, the first aircraft component surface can experience a temperature change that activates the TE device 76, with TE device 76 configured to convert heat energy into electrical current that can be delivered to power at least one of the first aircraft component that can be an electrically-powered component and a second aircraft component that can be an electrically-powered component.

Similar to the arrangement outlined in diagram 70b, as shown in diagram 70c, electrical current can be directed from the energy storage device, on demand, to power one or both of the first and second aircraft components 74, 75, respectively, for example, on demand. The release of stored electricity from the energy storage device can be selected when the TE device is in operation, or when the TE device is not in operation.

As stated herein, according to further present examples, the highly flexible thermoelectric composite devices can be associated with and otherwise positioned adjacent to or positioned in direct contact with aircraft manufacturing facility component surfaces associated with the manufacture of an aircraft, for example, in an aircraft manufacturing facility. According to these examples, the TE devices can harness, scavenge, etc., the "waste heat" that would otherwise be lost to a manufacturing environment and convert the waste heat into electrical energy that can be directed to power an aircraft manufacturing facility component that is in communication with the thermoelectric device.

In other present examples, an energy storage device can be in communication with the TE device in an electrical circuit with the energy storage device charged by the electrical current produced by the TE device(s). When a thermal gradient is not present, and the TE device is not operating, energy from the energy storage device can be directed from the charged energy storage device to power an electrically-powered aircraft manufacturing component in the aircraft manufacturing facility (referred to equivalently herein as the "aircraft manufacturing environment"). The energy storage device (that can be, for example, a rechargeable lithium ion battery) can be removable from the electrical circuit and brought into contact with a remotely-located aircraft manufacturing component to power the remotely-located component. In other examples, the energy storage device can release a charge to an electrical circuit (e.g., a central electrical circuit) into which other manufacturing components can be "plugged" to receive electrical energy from the energy storage device or from the TE device in operation.

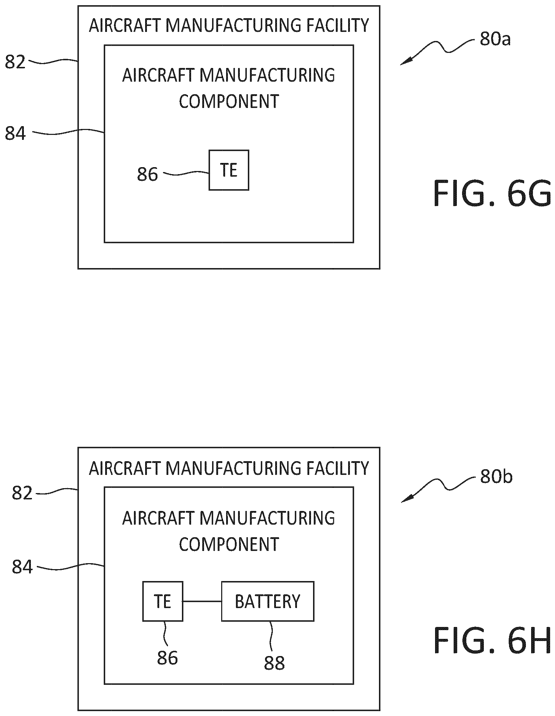

FIG. 6G shows diagram 80a illustrating an aircraft manufacturing facility 82 comprising an associated aircraft manufacturing component 84 that further comprises a TE device 86 positioned adjacent to or in direct contact with the aircraft manufacturing component surface. According to present examples, the aircraft manufacturing component surface emits heat during operation, or is located within an aircraft manufacturing facility and is positioned adjacent to or in contact with a heat-emitting source such that the component surface absorbs and then radiates and/or emits a portion of the absorbed heat from a component surface such that the component surface sustains a temperature change (e.g., temperature increase) causing a temperature gradient within the associated TE device. In the presence of the temperature gradient, the TE device is configured to harness, scavenge, etc., the "waste heat" that would otherwise be lost to a manufacturing environment, with the TE device configured to convert the waste heat into electrical energy that can be used to power an aircraft manufacturing component or that can be stored in, for example, an energy storage device and directed from the energy storage device to power an aircraft manufacturing component.

FIG. 6H shows diagram 80b directed to another example where TE device 86 is further in communication, for example, via an electrical circuit, with an energy storage device 88. As shown in FIG. 6H, the TE device 86 is positioned adjacent to or in direct contact with an aircraft manufacturing component surface of the aircraft manufacturing component 84 within an aircraft manufacturing facility 82 such that the TE device reacts to the change in temperature of the aircraft manufacturing component surface and experiences a temperature gradient across the TE device that enables the TE device to convert heat energy into electrical current from the scavenged waste heat at the aircraft manufacturing component surface of the aircraft manufacturing component.

According to one present example, in diagram 80b, if the aircraft manufacturing component is itself or comprises an electrically-powered aircraft manufacturing component, 1) the electrical current generated by the TE device can be directed from the TE device via an electrical circuit back into the aircraft manufacturing component; and/or 2) the electrical current generated by the TE device can be directed from the TE device via an electrical circuit to the energy storage device 88 (that can be, for example, a rechargeable lithium ion battery; and 3) an electrical charge stored in the energy storage device 88 can be released, on demand, and directed to power the electrically-powered aircraft manufacturing component.

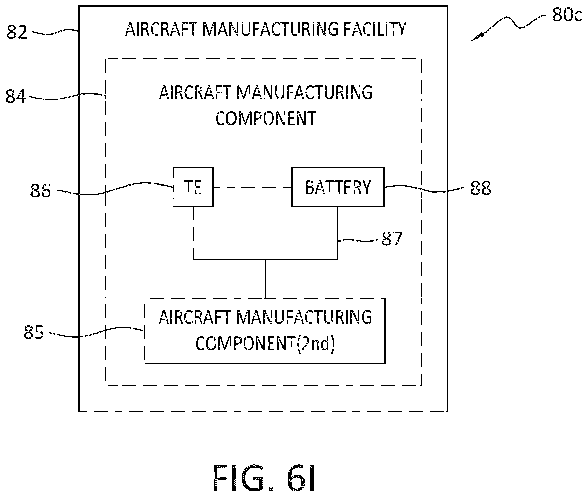

FIG. 6I shows a block diagram 80c illustrating another present example, where first aircraft manufacturing component 84 within an aircraft manufacturing facility 82 comprises the TE device 86 configured to scavenge and redirect energy in the form of heat energy from a first aircraft manufacturing component surface into converted electrical energy, with the electrical energy directed from the TE device 86 via an electrical circuit 87 to: 1) an energy storage device 88 that is in communication with the TE device; and/or 2) to a second aircraft manufacturing component 85 that is also in communication with an electrical circuit 87; and/or 3) to an energy storage device 88. In this example, the first aircraft manufacturing component can experience a temperature change that activates the TE device 86, with TE device 86 configured to convert heat energy into electrical current that can be delivered to power a second aircraft manufacturing component that can be an electrically-powered manufacturing component.

Similar to the arrangement outlined in diagram 80b, as shown in diagram 80c electric current can be directed from the energy storage device, on demand, to power one or both of the first and second aircraft components 84, 85, respectively, for example, on demand. The release of stored electricity from the storage batter can be selected when the TE device is in operation, or when the TE device is not in operation.

As mentioned herein, with respect to another example, the energy storage device (that can be, for example, a rechargeable lithium ion battery) can be removable from the electrical circuit and brought into contact with a remotely located aircraft manufacturing component within the aircraft manufacturing facility to power an electrically-powered aircraft manufacturing component (e.g., a cordless component). In other examples, the energy storage device can release a charge to an electrical circuit (e.g., a central electrical circuit) into which other manufacturing components can be "plugged" to receive electrical energy from the energy storage device or from the TE device in operation.

According to present apparatuses, systems, and methods, "self-sustaining" power generating devices are disclosed to reduce weight and energy consumption, and facilitate autonomous sensing, thus increasing safety and reliability. The presently disclosed highly flexible thermoelectric composite devices (referred to equivalently herein as "TE devices") are ideal for electrical power generation from aircraft assemblies, as well as powering temperature sensors for aircraft structures, (referred to equivalently herein as an "aircraft component" and an "aircraft assembly") as energy conversion/generation occurs continuously due to a heat flux provided by aircraft structures during aircraft operation, as well as heat fluxes generated into regions proximate to such aircraft structures.

That is, according to present examples, heat from, for example, an engine case or other heat-emanating aircraft structure (e.g., during aircraft operation can be harvested through the presently disclosed TE devices that can, for example, power micro-electromechanical system (MEMS) sensors or monitor the change in temperature gradient while they withstand structural deformations caused by repeated mechanical loads and/or repeated thermal expansions.

Present power generation/energy harvesting applications are made possible by the presently disclosed highly flexible TE devices that provide a conformal thermal contact between the highly flexible TE device and a heat source. The present highly flexible TE devices provide repeatably and reliably extensible TE devices that obviate the limitation of typical semiconductors soldered to inflexible electrodes, and instead provide TE devices with high efficiency and that are not prone to mechanical and electrical failure. Present highly flexible thermoelectric composite devices comprise soft multifunctional composites that are synthesized to provide enhanced thermal transport and excellent conformity at the contact area between the device and the heat source. The present TE devices show record high power generation; generating an open-circuit voltage of 440 mV and a power density equal to or approximately equal to 550 µW/cm⁻² at ΔT equal to 60°C, while being able to be stretched to more than 30% tensile strain up to at least 15,000 loading cycles or at least about 15,000 loading cycles.

Present examples contemplate incorporating, in an aircraft environment, the presently disclosed highly flexible thermoelectric (TE) composite devices acting themselves as thermal sensors. In some alternate examples, highly flexible TE composite devices are placed into an electrical circuit in communication with, and configured to, power thermal sensors in the event of an electrical interruption aboard an aircraft. The "high flexibility" of the present highly flexible TE composite devices is defined as the ability of the TE composite devices to maintain electrical generation capacity and structural integrity (e.g., by converting a thermal gradient into electrical energy) while enduring structural deformation in the form of stretching the area of the TE composite device by 30% (e.g., a 30% strain) over 15,000 cycles while realizing a miniscule change in resistance capability. The characteristic of the present TE composite devices enduring repeated structural deformation without sacrificing performance is referred to herein as the "stretchability" of the present highly flexible TE composite device; with "stretchability" including deformations that include, for example, stretching, twisting, bending, etc.

The present TE composite devices can comprise a printed liquid metal electrode that can be a self-healing electrodes that can withstand, for example, puncturing, yet maintain the ability to efficiently convert a thermal gradient into electricity.

The present highly flexible TE composite device comprises an elastomer-based substrate material further comprising conductive materials that are not only highly flexible, but that significantly increase performance and durability of the TE composite device by maintaining a high level of thermal gradient to electrical energy performance over a selected life of the TE composite device such that the TE composite device surpasses known structural deformation testing as described herein.

The present TE composite devices overcome previous issues concerning the use of elastomers exhibiting an undesired low thermal conductivity that previously caused inefficient heat transfer across a thermal gradient. Present TE composite devices overcome previous unacceptable TE device architecture by incorporating new functional filler materials into the TE composite device structure. Such functional filler materials include liquid metal alloys of gallium (e.g. eutectic gallium-indium (EGaIn)) to form a flowable electrical interconnect within the TE composite devices.

According to present examples, the selected liquid metal incorporated into the TE composite device structure comprises a high thermal conductivity (20-30 Wm⁻¹ K⁻¹) to enhance a selected thermal management. According to present examples, liquid metal droplets are provided as a dispersion within elastomer composites to provide a selected thermal conductivity and electrical insulation in addition to providing selected physical properties that enable first time usage of the present TE composite devices is selected application and in selected locations for selected application not previously possible.

According to present examples, liquid metal elastomer composites liquid metals can be served as both thermal interface materials and electrical interconnectors with their surfaces selectively patterned to create conductive traces. In some examples, the improved TE composite devices can generate a peak open-circuit voltage of 440 mV and a power density of 550 µW cm⁻²) at a temperature gradient of 60°C or about 60°C.

According to present examples, in some examples, 3D printing techniques are incorporated to manufacture the present TE composite devices, with the printed TE device comprising a plurality of layers including, in one example, two thermal interface elastomer layers separated by one insulation layer that can, for example, encapsulate bismuth telluride (Bi₂Te₃) thermoelectric semiconductors. According to a present example, the printed liquid metal elastomer composite with high thermal conductivity serves as the thermal interface material with the insulation layer printed with hollow microspheres embedded in the elastomer to reduce both the density and the thermal bypass around the TE semiconductors, with a sprayed liquid metal (using a stencil and coating L:M via airbrush) to function as a stretchable electrical interconnect between semiconductors.

According to present examples, the highly flexible TE composite devices exhibit significantly high steady-state voltage, with a high achievable heatsink performance believed to be due to an increased surface area resulting in an enhanced heat dissipation on the side not directly attached to aircraft assembly surfaces, the "cold side".

EXAMPLE 1 shows an exemplary manufacturing method of the present TE composite devices.

### EXAMPLE 1

Additive manufacturing printing steps are conducted on the array of TE pellets. Inorganic p/n-type thermoelectric semiconductors are paired and arranged, for example, diagonally inside a mold and assembled in alternating order to form a complete circuit after printing the electrical interconnects. Bismuth telluride (Bi₂Te₃) was selected as the TE material as having a low lattice thermal conductivity and high electrical conductivity at room temperature. After arrangement of the Bi₂Te₃ pellets, a thermal insulation layer was printed to fill gaps between pellets. The ink selected for the thermal insulation layer (e.g., middle layer) incorporated uniformly dispersed hollow thermoplastic microspheres (e.g., Expancel°, Nouryon Chemicals, Chicago, IL). The embedded microspheres reduce thermal density and the hollow microsphere elastomer composite (HMEC) with the low thermal conductivity helps to transfer most of the heat through thermoelectric semiconductors and to the cold side of the thermoelectric device. This resulting increased heat flux contributes to higher power generation of the TE composite devices.

After curing the insulation layer, liquid metal (Eutectic Indium Gallium) is sprayed over the TE pellets using an airbrush to create interconnects between P- and N-type TE pellets.

An electrically insulating liquid metal-elastomer composite with high thermal conductivity was printed on top to serve as the stretchable thermal interface layer. The embedded liquid metal inclusions in this layer are significantly small (diameter less than 8 µm) to ensure electrical insulation, eliminate LM leakage, and increase device endurance. The same steps were then applied to the other side to complete fabrication of the present highly flexible, highly deformable, and stretchable TE composite devices.

Present representative TE composite devices comprising 120 TE pellets had a final dimension of 51.5 x 32 x 2.2 mm³, with the fill factor calculated to be 14.27%; indicating the area fraction filled by the TE materials. The present highly flexible TE composite devices possessed selected flexibility to be placed into direct contact with contoured, curved surface with the fill factor of 14% or about 14% having high energy harvesting performance and structural integrity without sacrificing desired and selected stretchability. In further examples energy harvesting capability can be increased even if a degree of stretchability is sacrificed.

Functional elastomer composites can be formulated to print components of the TE devices, including, for example, 1) 50% volume fraction hollow microsphere elastomer composite (incorporated in the TE device to serve as a thermal insulation layer between hot and cold sides of the final TE composite device); 2) 50% volume fraction liquid metal elastomer composite with sub-5 µm inclusions. Ecoflex 00-30 was used as the matrix phase while fillers and processing parameters were adjusted to make the two composite materials for the purpose of tailoring selected properties and for the purpose of achieving a desired degree of uniformity within the printed layer(s) (e.g., avoiding sedimentation of the dispersion, etc.).

According to present examples, the high flexibility of the highly flexible TE composite devices affords use of the present TE devices for energy harvesting in areas and locations on structures, including, for example, contoured structures located in areas that were previously difficult to access and/or difficult to install highly efficient thermoelectronics that were not highly flexible. As stated herein, the present highly flexible TE composite devices are considered to have suitable life and serviceable duration when such devices, as the present devices do, survive and complete 15,000 cycles at a maximum strain of 30%, and remain fully functional without sustaining appreciable electrical or mechanical failure. Present highly flexible TE composite devices exhibited electrical stability with Voc of the tensile specimen before (32 mV before testing) and after (approximately 32 mV after testing) being subjected to testing of 15,000 cycles at 30% strain (mechanical loading) at ΔT = 40°C; with the TE composite devices further appearing fully intact after the 15,000 loading cycles.

Further, regarding structural integrity of the stretchable and highly flexible TE composite devices, the printed TE devices maintain functionality over time, with internal resistance and open-circuit voltage measured three months after fabrication with no change compared to initial measurements.

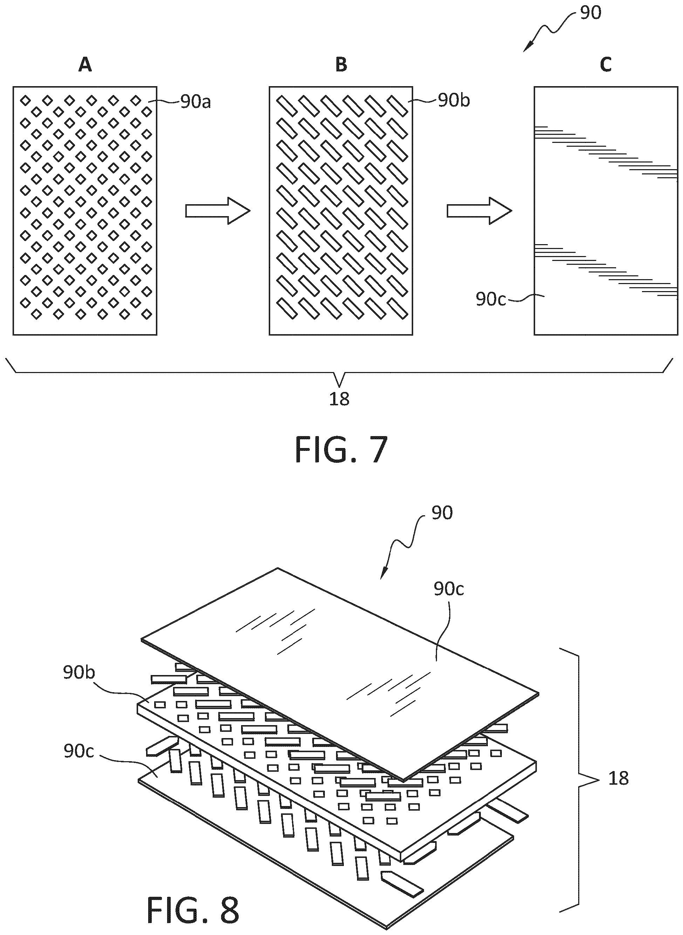

An example of the present TE device is shown in FIGs. 7, 8, 9, 10, 11, and 12. FIG. 7 shows a layer-by-layer manufacturing/fabrication progression for the present TE device "stack" 90 of the TE device 18. In one example, as shown in FIG. 7, in step "A" of the progression, TE pellets are placed into an arrangement and hollow microsphere elastomer composite (HMEC) is printed as a thermal insulation layer 90a. In step "B", a liquid metal interconnect 90b is formed by stencil printing onto the layer. In step "C" a printed liquid metal elastomer composite (LMEC) thermal interface layer 90c is formed. FIG. 8 is an exploded view of a TE device stack 80 for TE device 18 illustrating the orientation of formed/printed layers 90a, 90b, 90c of the present TE device 18 in a stacked orientation.

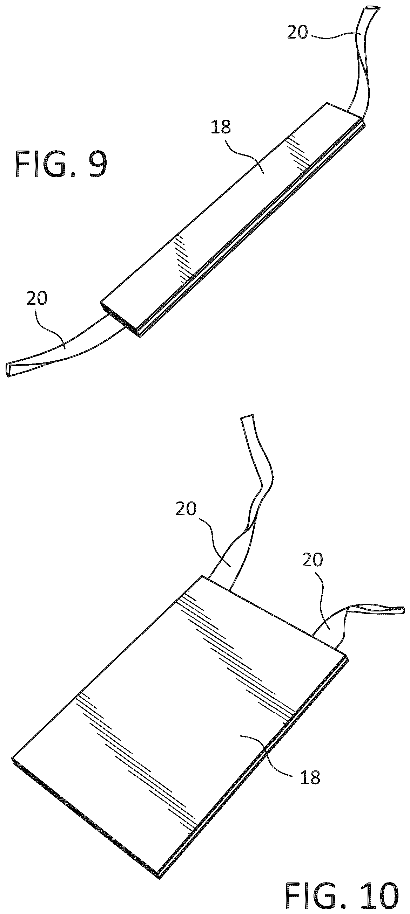

FIGs. 9 and 10 illustrate the TE device 18 comprising electrical leads 20 that can be positioned and otherwise formed into the TE device 18 having a non-limiting selected dimension in accordance with final use constraints, with the electrical leads 20 configured to contact an electrical circuit (not shown in FIGs. 9, 10) for the purpose of directing electricity generated by the TE device 18 into such circuit. FIGs. 9 and 10 further illustrate (although not necessarily drawn to scale) the varying dimensions of the TE devices made and used, according to present examples; with the TE device 18 shown in FIG. 9 having a significantly greater length as compared to width (e.g., a length:width ratio of greater than 5:1 or about 5:1 and, as shown, being 7:1 or about 7:1). As shown in FIG. 10, the TE device 18 shown in FIG. 10 presents as having a length:width ratio of less than 2:1 or about 2:1, and, for non-limiting illustration purposes only, appears as 1.5:1 or about 1.5:1.

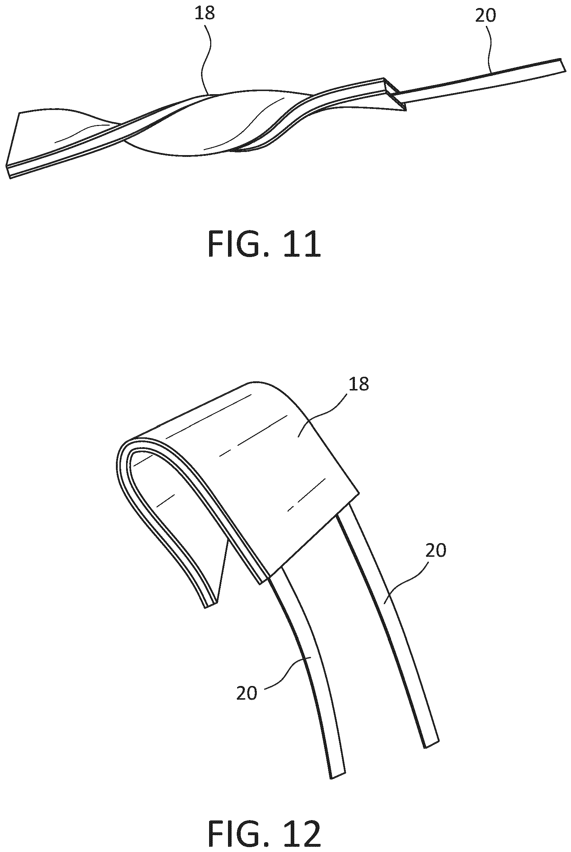

As shown in FIGs. 11 and 12, the present highly flexible thermoelectric composite devices 18 with incorporated electrical leads 20 are configured to maintain their electrical generation capabilities and function while being capable of significant deformation of the type shown in FIGs. 11 and 12, making the present TE devices useful and able to be incorporated into and on complex aircraft assembly surfaces that can include curved surfaces, surfaces of irregular and/or complex geometry, etc.

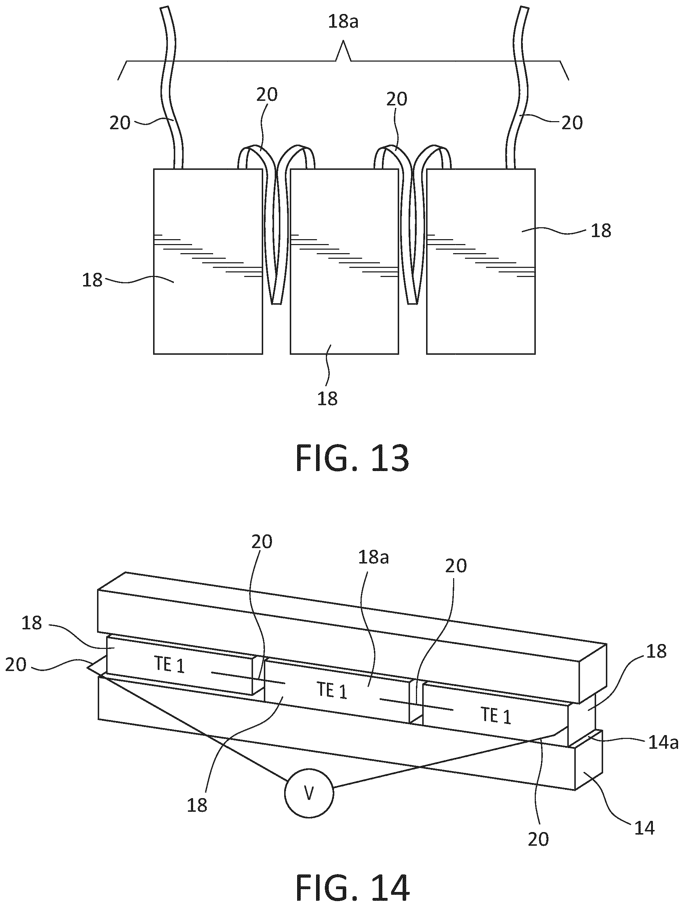

FIGs. 13, 14, and 15 depict a present TE device array comprising a plurality of TE devices 18 linked in series via electrical leads 20. As shown in FIG. 13, TE devices 18 are configured in series and in communication with one another via electrical leads 20 to form TE device array 18a. FIG. 14 shows the TE devices 18 joined in series to form TE device array 18a deployed in position against aircraft assembly surface 14a of aircraft assembly 14, that can be a heat-emitting aircraft assembly/aircraft assembly surface. When aircraft assembly 14 emits heat, a thermal gradient is formed across the TE devices 18 such that the TE devices 18 that comprise the TE device array 18a convert the heat energy emanating from assembly 14 into electricity and with the electricity produced by the TE device array 18a being greater than the electricity produced by an individual TE device 18.

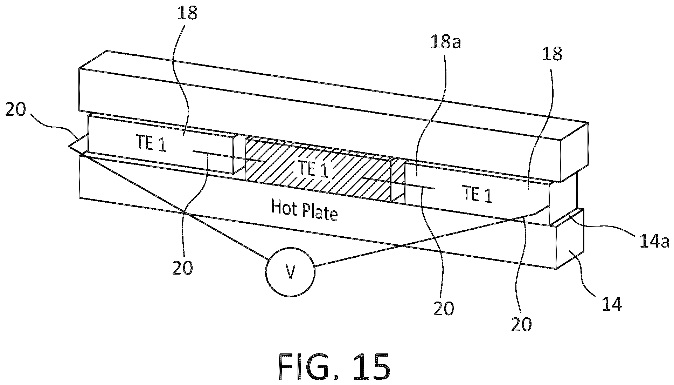

According to present examples, the flexibility achieved within the present TE device is, at least in part, achieved by the composite material components within the composite layers exhibiting a fluid-type behavior such that the TE devices are capable of sustaining a modicum of damage (e.g., a puncture) that can be "self-healed" as the liquid phase conductor within the composite layers rearrange to reform and maintain a conductive capability. In addition, placing TE devices in series further ensures that if one TE device incurs damage, the entire TE device array can continue to operate and continue the conversion of heat into electricity and maintain an uninterrupted delivery of a manufactured electrical charge from the TE devices to, for example, an electrical circuit. As shown in FIG. 15, TE device array 18a comprises a plurality of TE devices 18 placed in series with the "shaded" TE device in the center having sustained some degree of damage, but with the TE device array 18a still able to function.

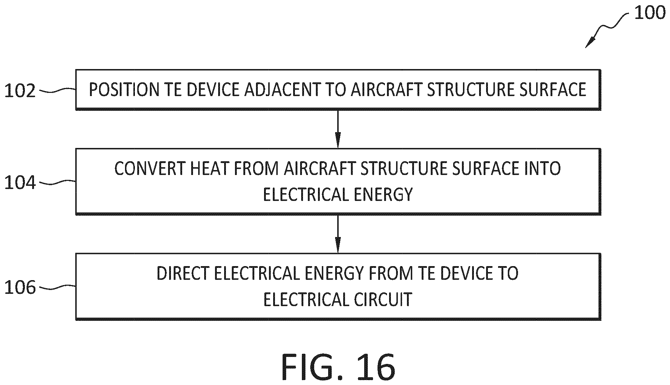

FIG. 16 through FIG. 25 are flowcharts outlining methods, according to present examples. FIG. 16 illustrates a method 100 of manufacturing an aircraft in an aircraft manufacturing facility (that includes, for example, harvesting energy from the "shop floor" environment, etc.) according to present examples, with the method 100 including providing an aircraft assembly, with the aircraft assembly comprising an aircraft structure surface, and with the aircraft assembly surface configured to emit an amount of heat from the aircraft assembly surface during operation of the assembly. The method 100 further includes positioning 102 at least one highly flexible thermoelectric composite device adjacent to the aircraft assembly surface, with the highly flexible thermoelectric composite device including at least one electrical lead in communication with the highly flexible thermoelectric composite device, and with the at least one electrical lead further in communication with an electrical circuit. Method 100 further includes converting 104 into electrical energy an amount of heat from the aircraft assembly surface, and directing 106 the electrical energy from the highly flexible thermoelectric composite device to the electrical circuit.

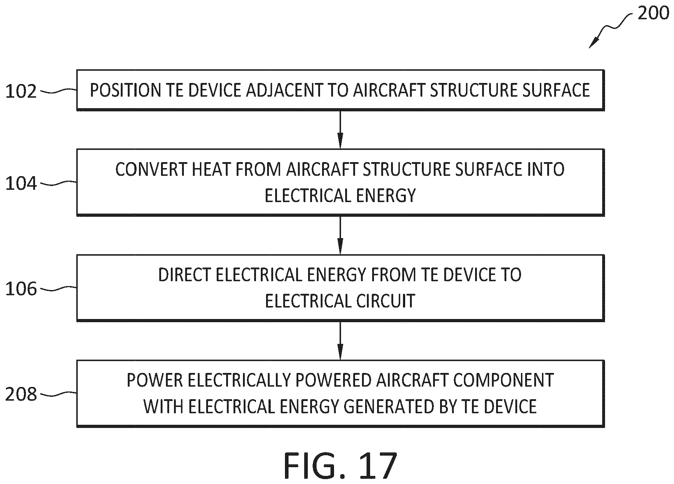

FIG. 17 is a flowchart outlining a method 200, according to present examples, with the method 200 including the examples of method 100, and additionally including powering 208 an electrically powered component with electrical energy directed from the at least one highly flexible thermoelectric composite device, with the electrically powered component in communication with at least one of the highly flexible thermoelectric composite devices and the electrical circuit.

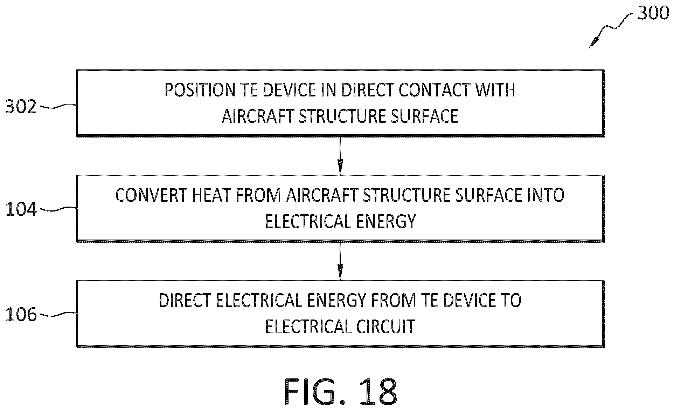

FIG. 18 is a flowchart outlining a method 300, according to present examples, with the method 300 including positioning 302 a highly flexible thermoelectric composite device in direct contact with an aircraft structure surface, and with the highly flexible thermoelectric composite device including at least one electrical lead in communication with the highly flexible thermoelectric composite device, and with the at least one electrical lead further in communication with an electrical circuit. Method 300 further includes converting 104 into electrical energy an amount of heat from the aircraft structure surface, and directing 106 the electrical energy from the highly flexible thermoelectric composite device to the electrical circuit.

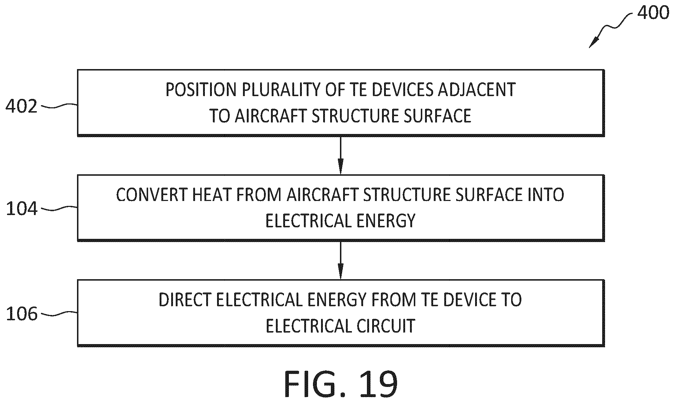

FIG. 19 is a flowchart outlining a further method 400 according to present examples, with method 400 including positioning 402 a plurality of highly flexible thermoelectric composite devices adjacent to an aircraft assembly surface of an aircraft assembly, with the highly flexible thermoelectric composite device including at least one electrical lead in communication with the highly flexible thermoelectric composite device, and with the at least one electrical lead further in communication with an electrical circuit. Method 100 further includes converting 104 into electrical energy an amount of heat from the aircraft structure surface, and directing 106 the electrical energy from the highly flexible thermoelectric composite device to the electrical circuit.

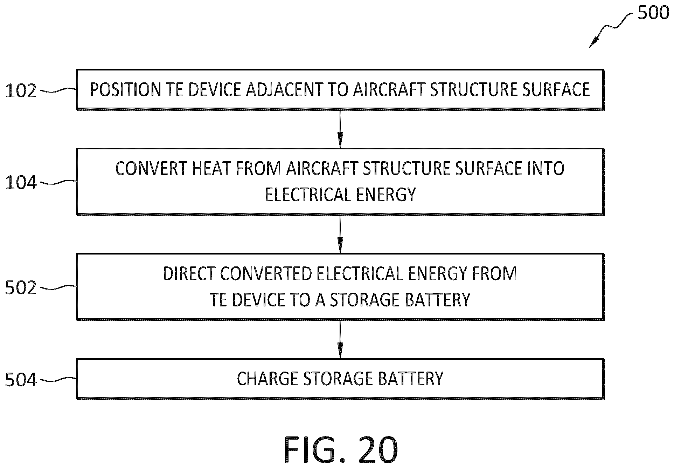

FIG. 20 is a flowchart outlining a method 500, according to present examples, with method 500 including positioning 102 at least one highly flexible thermoelectric composite device adjacent to an aircraft assembly surface of an aircraft assembly, with the highly flexible thermoelectric composite device including at least one electrical lead in communication with the highly flexible thermoelectric composite device, and with the at least one electrical lead further in communication with an electrical circuit. Method 500 further includes converting 104 into electrical energy an amount of heat from the aircraft assembly surface, directing 502 converted electrical energy from the TE device to an energy storage device, and charging 504 an energy storage device that can be a chargeable and/or rechargeable energy storage device (e.g., a lithium ion battery) with an electrical charge.

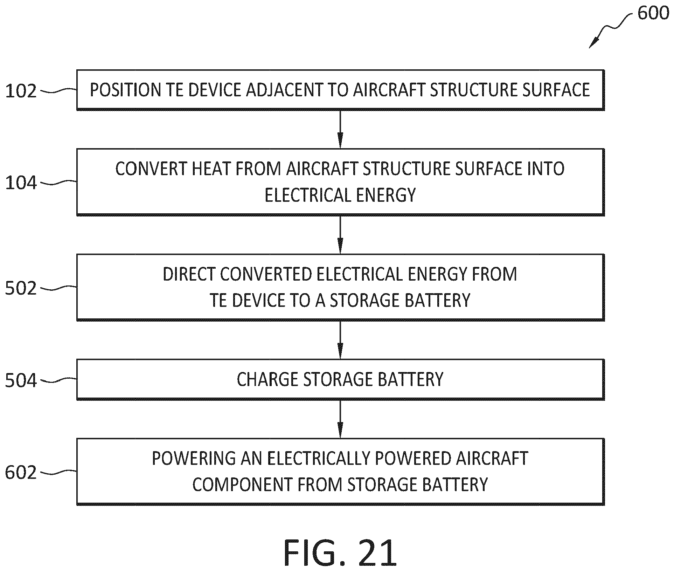

FIG. 21 is a flowchart outlining a method 600, according to present examples, with method 600 including the examples of method 500, and further including powering 602 an electrically-powered aircraft component with electricity delivered to the electrically-powered aircraft component from the energy storage device.

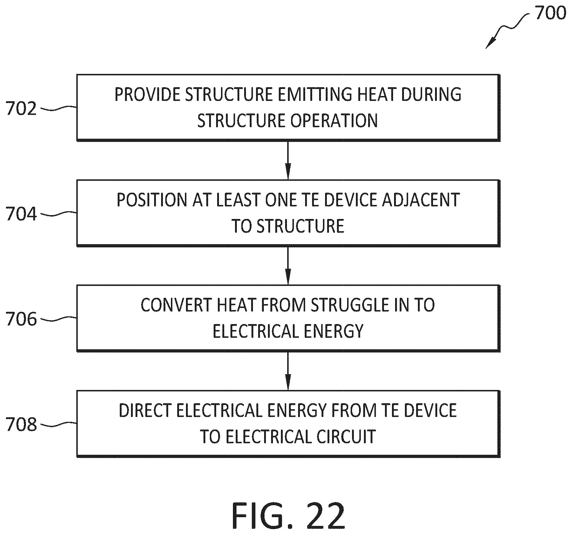

FIG. 22 is a flowchart outlining a method 700, according to present examples, with method 700 including providing 702 an aircraft manufacturing facility structure surface or aircraft manufacturing component surface configured to emit heat in an aircraft manufacturing facility (e.g., an aircraft manufacturing environment), for example, during operation of the aircraft manufacturing component, and positioning 704 at least one highly flexible thermoelectric composite device adjacent to at least one of the aircraft manufacturing facility structure surface emitting heat and the aircraft manufacturing component surface emitting heat in an aircraft manufacturing facility, for example, during operation of the aircraft manufacturing component. Method 700 further includes converting 706 into electrical energy heat emitted from at least one of the aircraft manufacturing facility structure and the aircraft manufacturing component during operation of the aircraft manufacturing component, and directing 708 the electrical energy to an electrical circuit, with the TE device in communication with the electrical circuit.

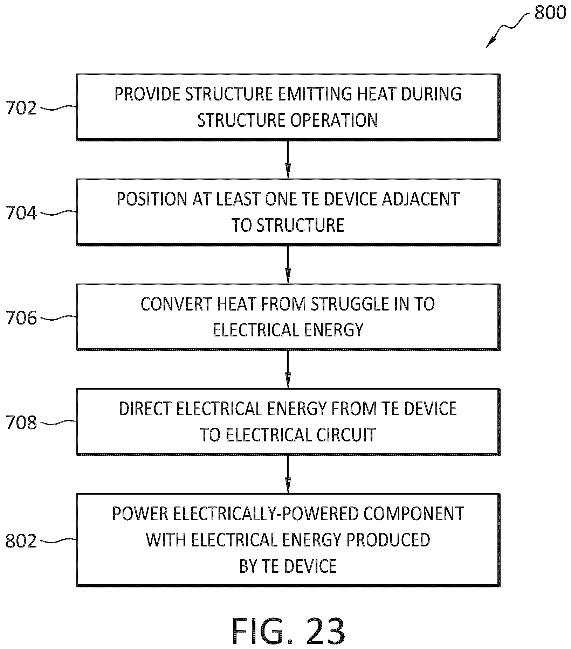

FIG. 23 is a flowchart outlining a method 800, according to present examples, with the method 800 including the examples of method 700, and further including powering 802 an electrically-powered component in an aircraft manufacturing facility with electrical energy produced by the TE device.

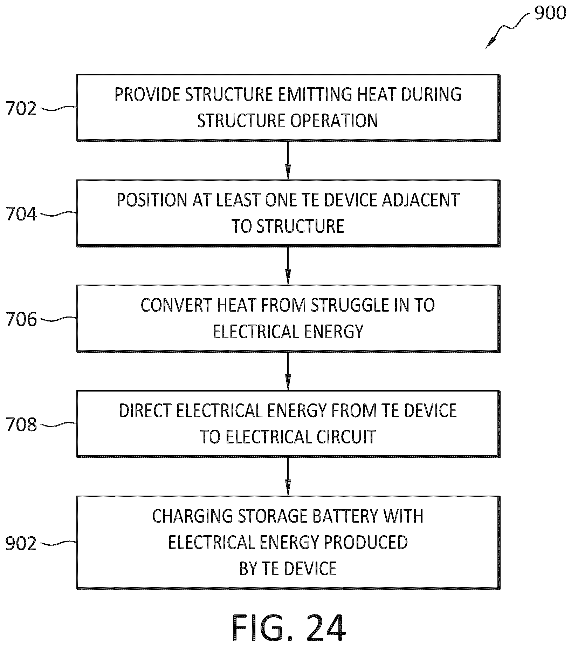

FIG. 24 is a flowchart outlining a method 900, according to present examples, with method 900 including the examples of method 700, and further including charging 902 an energy storage device (that, e.g., can be a chargeable or re-chargeable energy storage device that can be, for example, a battery that can be a lithium ion battery) with electrical energy produced by the TE device.

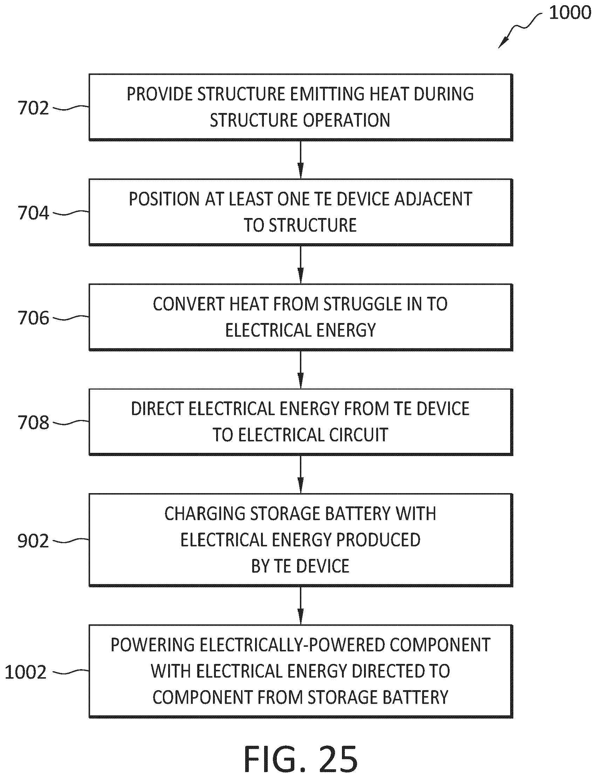

FIG. 25 is a flowchart outlining method 1000, according to present examples, with method 1000 including the examples of method 900, and further including powering 1002 an electrically-powered component with electrical energy directed to the electrically-powered component from the energy storage device.

The apparatuses and systems shown in any of FIGs. 1, 2, 3, 4, 5A, 5B, 6A-6I, 7, 8, 9, 10, 11, 12 13, 14, and 15 can be implemented in one or more of the methods outlined in FIGs. 16, 17, 18, 19, 20, 21, 22, 23, 24, and 25.

The present examples may, of course, be carried out in other ways than those specifically set forth herein without departing from essential characteristics of the disclosure. The present examples are to be considered in all respects as illustrative and not restrictive, and all changes coming within the meaning of the present claims are intended to be embraced therein.

The following clauses present further examples.

Clause 1. An aircraft assembly (14) comprising: an aircraft assembly surface (14a) of an aircraft assembly, said aircraft assembly surface configured to emit heat; at least one flexible thermoelectric composite device (18), said flexible thermoelectric composite device comprising at least one electrical lead (20) in communication with the flexible thermoelectric composite device, said at least one electrical lead further in communication with an electrical circuit (30); and wherein: said at least one flexible thermoelectric device is positioned adjacent to the aircraft assembly surface; and, optionally, the at least one flexible thermoelectric composite device (18) is an at least one highly flexible thermoelectric composite device (18).

Clause 2. The aircraft assembly (14) of Clause 1, wherein the at least one flexible thermoelectric device is in direct contact with the aircraft assembly surface (14a).

Clause 3. The aircraft assembly (14) of Clause 1 or 2, wherein said flexible thermoelectric composite device is configured to sustain a temperature gradient during operation of the aircraft assembly (14).

Clause 4. The aircraft assembly (14) of any of Clauses 1 to 3, wherein the aircraft assembly (14) is configured to generate heat.

Clause 5. The aircraft assembly (14) of any of Clauses 1 to 3, wherein the aircraft assembly (14) is configured to emit heat, said aircraft assembly (14) comprising at least one of an aircraft engine (12), a bleed air duct, a heater, an electrical equipment bay (15), and an aircraft cabin assembly.

Clause 6. The aircraft assembly (14) of Clause 5, wherein the aircraft assembly (14) is an aircraft cabin assembly that comprises at least one of a sidewall, a passenger seat, an electronics unit, a duct, and combinations thereof.

Clause 7. An aircraft (10) comprising the aircraft assembly of any of Clauses 1 to 6.

Clause 8. A method of harvesting (100) waste energy in an aircraft, the method comprising: positioning (102) at least one flexible thermoelectric composite device adjacent to an aircraft assembly surface of an aircraft assembly of an aircraft, said aircraft assembly surface configured to emit an amount of heat, said flexible thermoelectric composite device comprising at least one electrical lead in communication with the flexible thermoelectric composite device, said at least one electrical lead further in communication with an electrical circuit; converting (104) into electrical energy an amount of heat transferred to the flexible thermoelectric composite device from the aircraft assembly surface; and directing (106) the electrical energy from the flexible thermoelectric composite device to the electrical circuit; and wherein, optionally, the at least one flexible thermoelectric composite device is an at least one highly flexible thermoelectric composite device.

Clause 9. The method (200) of Clause 8 further comprising: powering (208) an electrically-powered aircraft component with electrical energy directed from the flexible thermoelectric composite device, said electrically powered aircraft component in communication with the electrical circuit.

Clause 10. The method of Clause 9, wherein the electrically-powered aircraft component comprises at least one of a temperature sensor, a power sensor, a lighting array, safety lighting, LED lighting, an ambient light sensor, a flight deck instrument panel, emergency equipment, communications equipment, an auxiliary power unit, fire suppression equipment, and combinations thereof.

Clause 11. The method of any of Clauses 9 or 10, wherein the flexible thermoelectric composite device is individually responsible for powering the electrically-powered aircraft component.

Clause 12. The method of any of Clauses 9 to 11, wherein the flexible thermoelectric composite device is an auxiliary power source provided to the electrically-powered aircraft component.

Clause 13. The method (500) of any of Clauses 8 to 12, further comprising: charging (504) a storage battery with at least a portion of the electrical energy directed from the flexible thermoelectric composite device to the storage battery, said storage battery in communication with the electrical circuit.

Clause 14. The method (600) of Clause 13 further comprising: powering (602) an electrically-powered aircraft component from the storage battery, said electrically-powered aircraft component comprising at least one of a temperature sensor, a power sensor, a lighting array, an ambient light sensor, a flight deck instrument panel, emergency equipment, communications equipment, an auxiliary power unit, fire suppression equipment, and combinations thereof.

Clause 15. The method of any of Clause 13 or 14, wherein a voltage booster is in communication with the electrical circuit.

Clause 16. The method of any of Clauses 13 to 15 wherein the storage battery is a rechargeable lithium ion battery.

Clause 17. The method of any of Clauses 8 to 16, wherein the aircraft assembly surface comprises at least one of an aircraft engine surface, a bleed air duct surface, a heater surface, an electrical equipment bay surface, and an aircraft cabin assembly surface.

Clause 18. The method of Clause 17, wherein the aircraft cabin assembly surface comprises at least one of a sidewall surface, a passenger seat surface, an electronics equipment bay surface, a duct surface, and combinations thereof.

Clause 19. The method (400) of any of Clauses 8 to 18, further comprising: positioning (402) a plurality of flexible/highly flexible thermoelectric composite devices adjacent to the aircraft assembly surface.

Clause 20. The method (300) of any of Clauses 8 to 19, further comprising: positioning (302) at least one flexible thermoelectric composite device in direct contact with the aircraft assembly surface.

Clause 21. A method of manufacturing an aircraft in an aircraft manufacturing environment, the method comprising: providing an aircraft manufacturing environment surface, said aircraft manufacturing environment surface configured to emit heat; positioning at least one flexible thermoelectric composite device adjacent to the aircraft manufacturing environment surface, said flexible thermoelectric composite device comprising at least one electrical lead in communication with the flexible thermoelectric composite device, said at least one electrical lead further in communication with an electrical circuit; converting into electrical energy an amount of heat emitted from the aircraft manufacturing environment surface; and directing the electrical energy from the flexible thermoelectric composite device to the electrical circuit; and wherein, optionally, the at least one flexible thermoelectric composite device is an at least one highly flexible thermoelectric composite device.

Clause 22. The method of Clause 21, further comprising: powering an electrically-powered component with electrical energy directed from the at least one flexible thermoelectric composite device, said electrically-powered component in communication with at least one of the flexible thermoelectric composite device and further in communication with the electrical circuit.

Clause 23. The method of Clause 21 or 22, further comprising: charging a storage battery with electrical energy directed from the at least one flexible thermoelectric composite device, said storage battery in communication with the electrical circuit during a battery charging cycle.

Clause 24. The method of Clause 23, further comprising: powering an electrically-powered component with electrical energy directed to the electrically powered component from the storage battery.

Clause 25. The method of any of Clauses 21 to 243, further comprising positioning the at least one flexible thermoelectric composite device in direct contact with the aircraft manufacturing environment surface.

Clause 26. The method of any of Clauses 21 to 25, further comprising incorporating the at least one flexible thermoelectric composite device into the aircraft manufacturing environment surface.

Clause 27. The method of any of Clauses 21 to 26, further comprising positioning a plurality of flexible/highly flexible thermoelectric composite devices in direct contact with the aircraft manufacturing environment surface.

Clause 28. The method of any of Clauses 21 to 27, further comprising incorporating a plurality of flexible/highly flexible thermoelectric composite devices into the aircraft manufacturing environment surface.

Clause 29. The method of any of Clauses 21 to 28, wherein the at least one flexible thermoelectric composite device is individually responsible for powering the electrically-powered component.

Clause 30. The method of any of Clauses 21 to 29, wherein the at least one flexible thermoelectric composite device is a source of auxiliary power provided to the electrically-powered component.

Clause 31. An electrically-powered component powered at least in part by the electrical energy directed to the electrically-powered component from the flexible thermoelectric composite device according to the method of Clause 22 or any of Clauses 23 to 30 when dependent upon Clause 22.

Clause 33. An aircraft manufactured according to the method of any of Clauses 21 to 30.

## Claims

1. An aircraft assembly (14) comprising:
an aircraft assembly surface (14a) configured to emit heat; and
at least one highly flexible thermoelectric composite device (18), said highly flexible thermoelectric composite device (18) comprising at least one electrical lead (20) in communication with the highly flexible thermoelectric composite device (18), said at least one electrical lead further in communication with an electrical circuit (30); and
wherein said at least one highly flexible thermoelectric device (18) is positioned adjacent to the aircraft assembly surface (14a).

2. The aircraft assembly (14) of Claim 1, wherein the at least one highly flexible thermoelectric device (18) is in direct contact with the aircraft assembly surface (14a).

3. The aircraft assembly (14) of Claim 1 or 2, wherein said highly flexible thermoelectric composite device (18) is configured to sustain a temperature gradient during operation of the aircraft assembly (14).

4. The aircraft assembly (14) of any of Claims 1 to 3, wherein the aircraft assembly (14) is configured to generate heat.

5. The aircraft assembly (14) of Claim 4, wherein:
the aircraft assembly (14) comprises at least one of an aircraft engine (12), a bleed air duct, a heater, and an electrical equipment bay (15); or
the aircraft assembly (14) comprises an aircraft cabin assembly (74) that, optionally, comprises at least one of a sidewall, a passenger seat, an electronics unit, a duct, and combinations thereof.

6. An aircraft (10) comprising the aircraft assembly (14) of any of Claims 1 to 5.

7. A method of harvesting (100) waste energy in an aircraft (10), the method comprising:
positioning (102) at least one highly flexible thermoelectric composite device (18) adjacent to an aircraft assembly surface (14a) of an aircraft assembly (14) of the aircraft (10), said aircraft assembly surface (14a) configured to emit an amount of heat, said highly flexible thermoelectric composite device (18) comprising at least one electrical lead (20) in communication with the highly flexible thermoelectric composite device (18), said at least one electrical lead (20) further in communication with an electrical circuit (30);
converting (104) into electrical energy an amount of heat transferred to the highly flexible thermoelectric composite device (18) from the aircraft assembly surface (14a); and
directing (106) the electrical energy from the highly flexible thermoelectric composite device (18) to the electrical circuit (30).

8. The method (500) of Claim 7, further comprising:
charging (504) a storage battery, optionally, a rechargeable lithium ion battery, with at least a portion of the electrical energy directed from the highly flexible thermoelectric composite device (18) to the storage battery, said storage battery in communication with the electrical circuit (30).

9. The method (200) of Claim 7 or 8, further comprising:
powering (208) an electrically-powered aircraft component with electrical energy directed from the highly flexible thermoelectric composite device (18), optionally via the storage battery, said electrically powered aircraft component in communication with the electrical circuit (30).

10. The method of Claim 9, wherein the electrically-powered aircraft comprises at least one of a temperature sensor, a power sensor, a lighting array, safety lighting, LED lighting, an ambient light sensor, a flight deck instrument panel, emergency equipment, communications equipment, an auxiliary power unit, fire suppression equipment, and combinations thereof.

11. The method of Claim 9 or 10, wherein the highly flexible thermoelectric composite device (18) is individually responsible for powering the electrically-powered aircraft component or the highly flexible thermoelectric composite device (18) is an auxiliary power source provided to the electrically-powered aircraft component.

12. The method of any of Claims 7 to 11, wherein a voltage booster is in communication with the electrical circuit (30).

13. The method of any of Claims 7 to 12, wherein:
the aircraft assembly surface (20a) comprises at least one of an aircraft engine surface, a bleed air duct surface, a heater surface, and an electrical equipment bay surface, and an aircraft cabin assembly surface (74) or
wherein the aircraft assembly surface (20a) comprises aircraft cabin assembly surface (74) that, optionally, comprises at least one of a sidewall surface, a passenger seat surface, an electronics equipment bay surface, a duct surface, and combinations thereof.

14. The method (400) of any of Claims 7 to 13, further comprising:
positioning (402) a plurality of highly flexible thermoelectric composite devices (18) adjacent to the aircraft assembly surface (20a), optionally in direct contact with the aircraft assembly surface (20a).

15. A method of manufacturing an aircraft in an aircraft manufacturing environment, the method comprising:
providing an aircraft manufacturing environment surface, said aircraft manufacturing environment surface configured to emit heat;
positioning at least one highly flexible thermoelectric composite device adjacent to the aircraft manufacturing environment surface, said highly flexible thermoelectric composite device comprising at least one electrical lead in communication with the highly flexible thermoelectric composite device, said at least one electrical lead further in communication with an electrical circuit;
converting into electrical energy an amount of heat emitted from the aircraft manufacturing environment surface; and
directing the electrical energy from the highly flexible thermoelectric composite device to the electrical circuit.
